# FASCICULE DE BREVET EUROPEEN

(11) **EP 2 320 567 B1**
(45) Date de publication et mention de la délivrance du brevet: **26.03.2014**
(21) Numéro de dépôt: 10189159.6
(22) Date de dépôt: 28.10.2010
(51) Int. Cl.: H03K 17/96

(54) **Circuit de raccordement de capteurs**
Schaltung zur Verbindung von Sensoren
Circuit for connecting sensors

(30) Priorité: 10.11.2009 FR 0957946
(43) Date de publication de la demande: 11.05.2011
(73) Titulaire: STMicroelectronics (Tours) SAS, 37100 Tours (FR)
(72) Inventeur: Boulin, Martial, 35000, RENNES (FR)
(74) Mandataire: Thibon, Laurent

(56) Documents cités:
- WO-A1-2008/048024
- US-A- 5 841 301
- US-A1- 2003 048 008

## Description

### Domaine de l'invention

La présente invention concerne de façon générale les circuits électroniques et, plus particulièrement, un circuit de raccordement de capteurs à un système numérique, par exemple un microcontrôleur.

Un domaine auquel s'applique plus particulièrement la présente invention est celui des automates programmables et des interfaces entre des capteurs de proximité et un microcontrôleur.

### Exposé de l'art antérieur

Les interfaces de raccordement de capteurs, couramment désignées "current limiter termination" (CLT), sont intercalées entre des capteurs fournissant une réponse électrique à deux états et les entrées analogiques d'un circuit électronique. Le rôle de ces interfaces est de mettre à niveau les signaux fournis par le capteur pour qu'ils soient compatibles avec les niveaux acceptables par le circuit électronique.

Une première famille de capteurs concerne des capteurs dits "deux fils" dans lesquels l'alimentation du capteur passe par la sortie de celui-ci, donc par l'interface entre le capteur et le microcontrôleur. Selon l'état de l'élément de détection ou de mesure du capteur, le capteur fournit un état haut ou bas c'est-à-dire qu'il connecte ou non la borne d'alimentation à la borne de sortie du capteur.

Une seconde famille concerne les capteurs dits trois fils dans lesquels l'alimentation du capteur est séparée du signal de sortie.

La tension d'alimentation du capteur est souvent différente de celle du microcontrôleur. C'est pourquoi le circuit d'interface est utilisé pour limiter le courant et pour fournir un signal acceptable par les entrées du microcontrôleur.

Toutefois, la différence entre les tensions d'alimentation engendre une forte dissipation dans les circuits d'interface, notamment pour des capteurs deux fils. Cette dissipation peut atteindre plusieurs watts pour des circuits destinés à traiter de nombreuses entrées.

Cette dissipation importante limite aujourd'hui le nombre d'entrées d'un même circuit d'interface.

Il serait souhaitable de disposer de circuits d'interface ayant un nombre d'entrées plus important.

Il serait par ailleurs souhaitable de réduire la dissipation du circuit d'interface.

Le document WO-A-2008/048024 décrit un dispositif de traitement d'un signal de capteur comprenant une source de courant, un intégrateur de rampe et un comparateur.

### Résumé

Un objet d'un mode de réalisation de la présente invention est de pallier tout ou partie des inconvénients des circuits d'interface usuels.

Un autre objet d'un mode de réalisation de la présente invention est de réduire la dissipation d'un circuit de raccordement de capteurs à un circuit électronique.

Un objet d'un autre mode de réalisation de la présente invention est de proposer une solution simple à mettre en oeuvre.

Un objet d'un autre mode de réalisation de la présente invention est de proposer une solution plus particulièrement adaptée aux capteurs de la norme 61131-2.

Pour atteindre tout ou partie de ces objets ainsi que d'autres, il est prévu un circuit de conversion de l'état d'un capteur en un signal interprétable par un circuit électronique, selon la revendication 1.

Selon un mode de réalisation de la présente invention, le rapport cyclique du train d'impulsions est supérieur à 10% et, préférentiellement, supérieur à 25%.

Selon un mode de réalisation de la présente invention, le capteur a une réponse impulsionnelle capacitive à l'état inactif.

Selon un mode de réalisation de la présente invention, le capteur est un capteur deux fils.

On prévoit également un circuit intégré comportant plusieurs circuits de conversion.

On prévoit également un procédé d'acquisition de l'état d'un capteur à destination d'un circuit électronique, par un circuit de conversion, dans lequel des instants d'échantillonnage d'un signal fourni par le comparateur sont synchronisés avec des fronts descendants des impulsions de commande de l'élément de commutation.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est un schéma bloc d'un exemple de système à capteurs du type auquel s'applique la présente invention ;
la figure 2 représente le schéma électrique d'un circuit de raccordement usuel d'un capteur deux fils ;
la figure 3 illustre la caractéristique tension-courant d'un capteur deux fils dans le gabarit défini par la norme 61131-2 ;
la figure 4 représente un circuit de raccordement d'un capteur deux fils selon un mode de réalisation de la présente invention ;
la figure 5A représente le schéma équivalent du circuit de la figure 4 avec un capteur deux fils en position ouverte ;
la figure 5B représente le schéma équivalent du circuit de la figure 4 avec un capteur deux fils en position fermée ;
la figure 6A illustre le fonctionnement du circuit de la figure 4, avec un capteur deux fils en position ouverte et un premier exemple de rapport cyclique ;
la figure 6B illustre le fonctionnement du circuit de la figure 4, avec un capteur deux fils en position fermée et le premier exemple de rapport cyclique ;
la figure 7A illustre le fonctionnement du circuit de la figure 4, avec un capteur deux fils en position ouverte et un deuxième exemple de rapport cyclique ;
la figure 7B illustre le fonctionnement du circuit de la figure 4, avec capteur deux fils en position fermée et le deuxième exemple de rapport cyclique ; et
la figure 8 représente le schéma électrique d'un capteur trois fils.

### Description détaillée

De mêmes éléments ont été désignés par de mêmes références aux différentes figures et les chronogrammes ont été tracés sans respect d'échelle. Pour des raisons de clarté, seuls les éléments utiles à la compréhension de l'invention ont été représentés et seront décrits. En particulier, les capteurs utilisés par le circuit d'interface décrit n'ont pas été détaillés, l'invention étant compatible avec tout capteur usuel. De plus, la destination des signaux fournis par le circuit d'interface n'a pas non plus été détaillée, l'invention étant là encore compatible avec les applications habituelles.

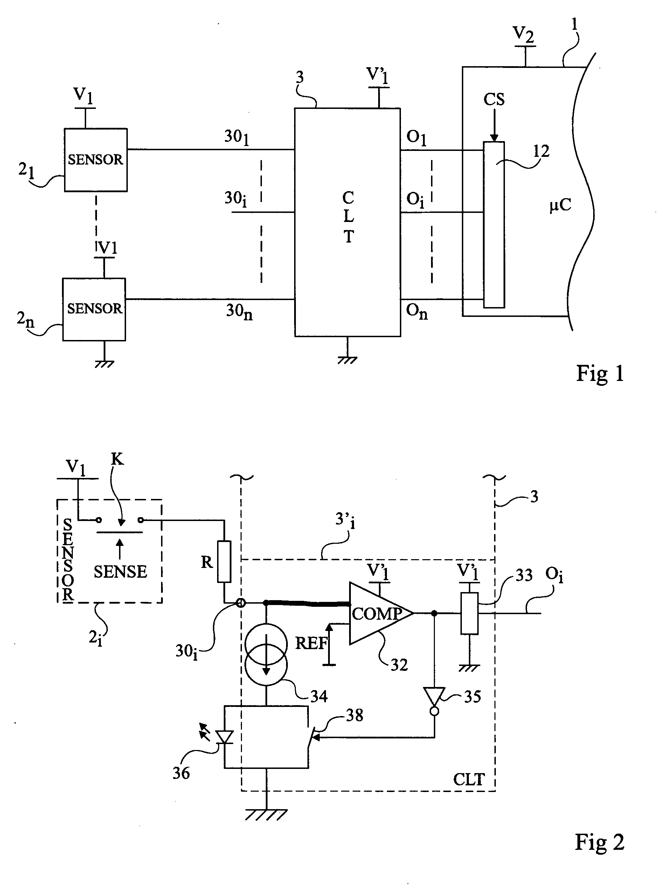

La figure 1 est un schéma bloc illustrant un système comportant un microcontrôleur 1 d'exploitation de signaux fournis par des capteurs (SENSOR) 2₁, ... 2ᵢ, ... 2ₙ (i étant compris entre 1 et n). Une borne de sortie de chaque capteur est reliée à une borne d'entrée 30₁, ... 30ᵢ, ... 30ₙ d'un circuit 3 d'interface (CLT) dont des sorties respectives O₁, ... Oᵢ, ... Oₙ sont connectées à des entrées du microcontrôleur 1 ou autre circuit électronique de traitement. Pour être exploités par le microcontrôleur, les signaux présents sur ses bornes d'entrées sont régulièrement échantillonnés (en parallèle ou séquentiellement). Cette fonction est illustrée par un bloc 12 commandé par un signal CS (Chip Select) du microcontrôleur.

Les différents capteurs 2i sont alimentés par une tension V₁ différente de la tension d'alimentation V₂ du microcontrôleur. Pour simplifier, tous les capteurs 2i ont été illustrés comme alimentés avec une même tension V₁. Cette tension peut toutefois être différente d'un capteur à un autre. Le circuit d'interface 3 est, par exemple, alimenté par la tension V'₁.

Dans l'exemple de la figure 1, on a illustré un exemple de capteurs 2₁ deux fils (dont la connexion à la masse est fournie par le circuit 3) et un exemple de capteurs 2ₙ trois fils (pourvu d'une connexion à la masse pour que l'alimentation du capteur soit dissociée du signal de sortie).

La figure 2 est un schéma électrique d'un exemple de capteurs deux fils 2i associé à un étage 3'i d'un circuit d'interface usuel. Typiquement, le capteur capte une information (symbolisée par un signal SENSE) qui conditionne l'état d'un interrupteur K ou équivalent. Une borne de l'interrupteur K reçoit la tension d'alimentation V₁ tandis que son autre borne est reliée, par l'intermédiaire d'une résistance R, à une borne d'entrée 30i du circuit 3. L'étage 3'i de conversion ou d'interface comporte un comparateur 32 (COMP) qui transmet son état à un circuit adaptateur de niveau à la tension V₂ générée à partir de la tension V'₁. Ce comparateur compare le niveau présent sur la borne d'entrée 30i à un niveau de référence REF. La sortie de l'adaptateur de niveau 33 est reliée à la borne de sortie de l'étage 3'i à destination du microcontrôleur. La borne 30i est par ailleurs reliée à la masse par l'intermédiaire d'un élément limiteur de courant 34 et à travers soit une diode électroluminescente (LED) 36 (ou tout autre indicateur visuel) soit un interrupteur 38 commandé par l'état de sortie du comparateur 32 au travers d'un inverseur 35. Dans l'exemple de la figure 2, l'interrupteur 38 est en parallèle avec la diode électroluminescente 36 entre le limiteur de courant 34 et la masse. Quand l'interrupteur K du capteur est ouvert, aucun courant ne circule dans la résistance R. Le niveau de la borne 30i est donc bas et la sortie du comparateur 32 fournit un niveau bas. L'inverseur 35 inverse ce niveau de sorte que l'interrupteur 38 est fermé et la diode 36, court-circuitée par l'interrupteur 38, est éteinte. Quand l'interrupteur K se ferme, un courant, limité par le limiteur de courant 34, se met à circuler, depuis la borne d'application de la tension V₁, dans la résistance R et dans l'interrupteur 38. Le niveau en entrée de mesure du comparateur 32 correspond au niveau fixé par la tension d'alimentation V₁ moins les chutes de tension aux bornes du capteur et de la résistance R. Quand ce niveau atteint la tension REF, la sortie du comparateur 32 bascule et présente un niveau haut. Ce changement d'état est interprété par le microcontrôleur 1, par exemple comme un état 1. Par ailleurs, l'interrupteur 38 s'ouvre et le courant circule alors dans la diode 36 confirmant visuellement l'état 1.

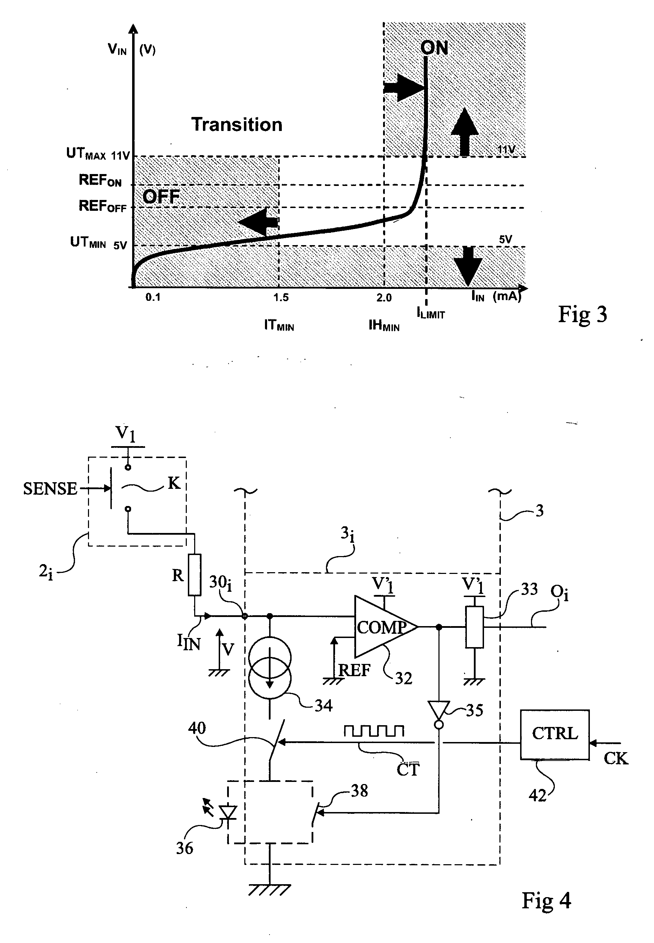

La figure 3 illustre le fonctionnement de l'étage 3'i de la figure 2 selon la norme 61131-2. Cette norme fixe non seulement des niveaux UTmin et UTmax de tension à la sortie du capteur K, respectivement en deçà duquel le capteur doit être considéré ouvert (OFF) et au delà duquel le capteur doit être considéré fermé (ON), mais également des niveaux ITmin et IHmin du courant dans la résistance R, respectivement en deçà duquel le capteur doit être considéré ouvert et au delà duquel le capteur doit être considéré fermé. Typiquement, d'après la norme 61131-2 à laquelle on se réfère à titre d'exemple, le niveau UTmin est de 5 volts, le niveau UTmax est de 11 volts, le niveau ITmin est de 1,5 milliampère ou de 2 milliampères respectivement pour les capteurs de type 3 ou de type 2 et le niveau IHmin est de 2 milliampères ou de 6 milliampères respectivement pour les capteurs de type 3 ou de type 2.

Les seuils de basculement en tension de l'interface 3'i associé à la résistance R sont illustrés en figure 3 sous la forme de deux niveaux REF_{OFF} et REF_{ON} faisant ressortir une hystérésis du comparateur.

Comme indiqué précédemment, la dissipation dans l'étage 3'i est importante. Il n'est pas rare de voir, avec un circuit d'interface classique à huit entrées de type 3, une dissipation supérieure à 500 milliwatts. Une telle dissipation limite le nombre d'entrées-sorties du circuit 3.

La figure 4 représente le schéma électrique d'un mode de réalisation d'un étage 3i d'un circuit d'interface 3. Dans cet exemple, on considère le cas d'un capteur deux fils symbolisé par l'interrupteur K. Comme précédemment, un comparateur 32 a une borne d'entrée reliée à la borne 30i et transmet, à travers l'adaptateur de niveau, sur sa borne de sortie Oᵢ, l'état du capteur à destination d'un microcontrôleur (non représenté). Le limiteur de courant 34 associé à la résistance série R permet de définir la tension à l'entrée du comparateur.

Selon le mode de réalisation représenté, un interrupteur 40 est intercalé entre le limiteur de courant 34 et le circuit indicateur (LED 36) d'une part et l'interrupteur 38 d'autre part.

L'interrupteur 40 est commandé par un bloc 42 (CTRL) fournissant un train d'impulsions. Le bloc 42 reçoit donc un signal d'horloge CK ou tout autre signal de commande permettant la génération d'un train d'impulsions de commande de l'interrupteur 40.

L'ordre entre l'interrupteur 40 et le circuit indicateur 36-38 dans l'association en série n'a pas d'importance. Toutefois, l'interrupteur 40 et ce circuit 36-38 sont de préférence côté masse dans l'association en série par rapport au limiteur de courant 34, de façon à limiter la tension à leurs bornes. En particulier, cela permet une commande de l'interrupteur 40 par un signal généré à partir d'une tension inférieure à la tension V₁.

La commutation du limiteur de courant 34 par l'interrupteur 40 permet de réduire la consommation, donc la dissipation dans l'étage 3i et dans le capteur K, donc de réduire la puissance fournie par la source de tension de niveau V₁. De préférence, la fréquence de commutation est comprise entre 100 hertz et quelque mégahertz.

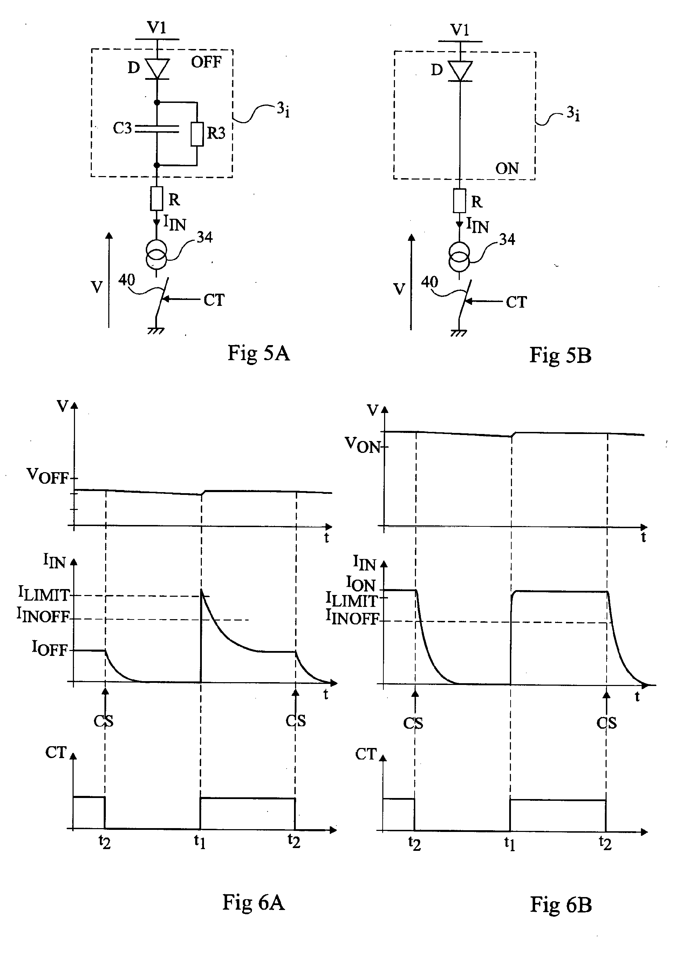

Les figures 5A et 5B sont des schémas électriques équivalents du capteur, en série avec la résistance R, la source de courant 34 et l'interrupteur 40 entre la borne d'application de la tension V₁ et la masse, respectivement pour le capteur à l'état ouvert (OFF) et à l'état fermé (ON).

Les figures 6A et 6B sont des chronogrammes illustrant des exemples de la tension V aux bornes du capteur et du courant I_{IN} sur la borne 30i pour un signal CT ayant un rapport cyclique de 50%, respectivement pour les positions ouverte (figure 5A) et fermée (figure 5B) du capteur 3ᵢ.

Lorsque le capteur est à l'état ouvert, il présente une impédance de type capacitive. Cela est illustré en figure 5A par un schéma équivalent du capteur constitué d'une diode D en série avec un condensateur C3 associé en parallèle avec une résistance R3. Sous l'effet de la commutation de l'interrupteur 40, on assiste à une évolution de la tension V sous forme de décharge capacitive entre deux impulsions du signal de commande CT.

Comme l'illustre la figure 6A, à chaque front (instant t1) montant du signal CT (instant où l'interrupteur 40 se ferme), un pic de courant apparaît sur l'allure I_{IN}. Puis, le courant décroit en suivant une allure capacitive jusqu'à un plateau à un niveau I_{OFF} tant que l'impulsion de commande est présente. A la fin de l'impulsion de commande (front descendant t2 du signal CT), l'interrupteur 40 s'ouvre. Le courant disparaît alors en suivant l'allure d'une décharge capacitive avec une constante de temps fonction des valeurs de la capacité équivalente C3 et de la résistance équivalente R3 du capteur. Le niveau de la tension V est fixé par les valeurs respectives de l'impédance du capteur (essentiellement de la résistance R3), de la résistance R et du limiteur de courant 34 dont les valeurs sont choisies pour que ce niveau reste en dessous du seuil UTmin (figure 3).

A l'état fermé (figure 5B), le capteur se comporte comme une diode D et son impédance est négligeable.

Comme l'illustre la figure 6B, à chaque front montant (instant t1) du signal de commande CT, c'est-à-dire à chaque fermeture de l'interrupteur 40, le courant croit brusquement jusqu'à atteindre un niveau I_{ON}. Il reste à ce niveau pendant toute la durée de l'impulsion (jusqu'à l'instant t2). A cet instant, l'interrupteur 40 s'ouvre et le courant décroît.

Côté tension V, le niveau reste fixé par le niveau V₁ moins les chutes de tension dans le capteur et la résistance R. Les dimensions de la source de courant et de la résistance R sont choisies pour que ce niveau soit supérieur au niveau V_{ON}.

On voit que, côté tension, le gabarit fixé par la norme (figure 3) est respecté. Toutefois, côté courant, cela dépend des instants de prise en compte de l'état de sortie du comparateur.

On tire profit de la décroissance du courant en forme de décharge capacitive pour synchroniser les instants d'acquisition (symbolisés par les instants CS aux figures 6A et 6B) avec les fronts descendants du signal CT. Ainsi, à l'état ouvert (figure 6A), le courant I_{OFF} est à cet instant inférieur au seuil I_{INOFF}. Par conséquent, que cela soit pour la tension ou pour le courant, l'acquisition considère bien le capteur comme ouvert. Le choix d'une acquisition en fin de créneau du signal impulsionnel évite de prendre en compte le pic de courant lors de la fermeture de l'interrupteur 40. A l'état fermé (figure 6B), le courant I_{IN} n'a pas encore décru et est encore supérieur au courant I_{INOFF}. De préférence, les composants sont dimensionnés pour qu'il soit même supérieur au courant I_{LIMIT}.

Les allures ci-dessus sont supposées en régime établi, c'est-à-dire postérieures à une phase d'établissement de la tension lors de la mise sous tension du capteur. Pour éviter de fausses détections au démarrage, le résultat de la détection n'est pris en compte qu'à l'issue d'une phase de démarrage (en pratique, quelques millisecondes).

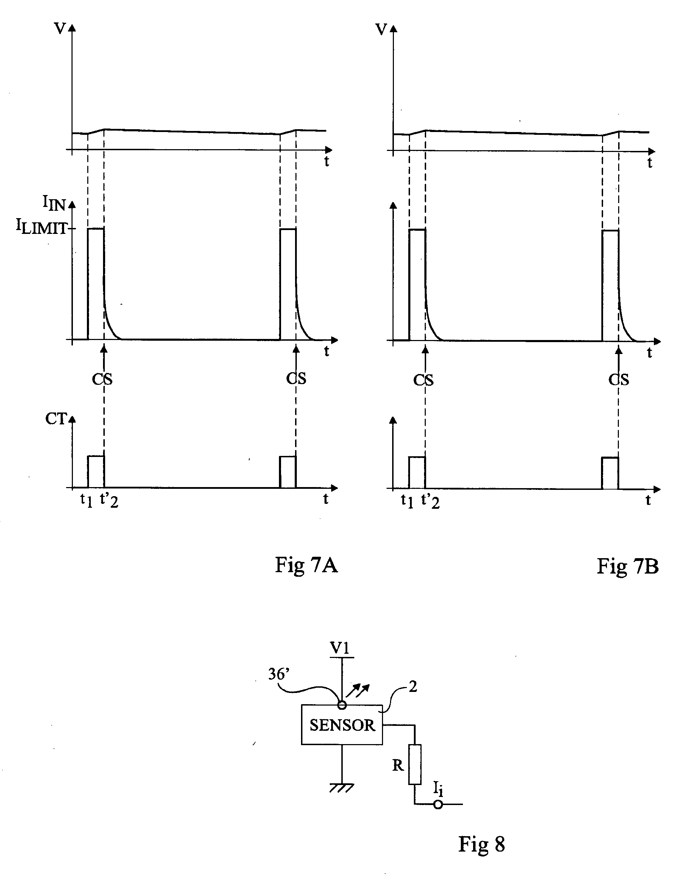

Les figures 7A et 7B illustrent le fonctionnement du capteur des figures 5A et 5B pour un signal de commande CT ayant un rapport cyclique plus faible (inférieur à 10%). Pour faire mieux ressortir le fonctionnement, on considère en plus le cas d'un signal de commande CT ayant une fréquence plus élevée qu'aux figures 6A et 6B. Comme pour les figures 6A et 6B, à chaque impulsion du signal de commande CT, le courant I_{IN} atteint le courant I_{LIMIT}. Toutefois, le faible rapport cyclique associé à la fréquence plus élevée conduit à ce qu'à la fin (instant t2') des impulsions de commande, synchronisée avec les instants CS d'acquisition, le courant n'a pas encore eu le temps de décroitre. Par conséquent, que le capteur soit ouvert ou fermé, la détection indique un capteur fermé (ON). La tension V reste à un niveau faible.

Il en découle que le circuit 3i n'est pas en mesure de distinguer l'état ouvert de l'état fermé.

Il ressort de ce qui précède que le rapport cyclique du signal de commande est choisi, en tenant compte des caractéristiques du capteur, pour que sa réponse impulsionnelle soit telle que le courant ait, à l'état OFF, diminué suffisamment aux instants d'acquisition.

Plus le rapport cyclique est faible, plus la dissipation est réduite. Toutefois, un compromis doit donc être fait en fonction de la réponse impulsionnelle du capteur.

La fréquence de commutation est, par exemple, comprise entre 100 hertz et quelques mégahertz et le rapport cyclique est supérieur à 10%, de préférence supérieur à 25%.

Selon un mode de réalisation préféré, le signal de commande CT correspond au signal d'horloge fixant les instants d'acquisition CS. En variante, la fréquence du signal CT est supérieure à celle du signal CS. Pour respecter la synchronisation des fronts descendants, la période du signal d'acquisition est alors un multiple entier de celle du signal de commande CT.

La figure 8 représente schématiquement un capteur 3 fils également utilisable avec l'interface décrite ci-dessus. Par rapport à un capteur 2 fils, la différence est que l'alimentation du capteur 2 est dissociée de celle de l'interface (le capteur a sa propre connexion à la masse).

Il en découle que, quand le capteur est ouvert, aucun courant ne circule dans la résistance R, indépendamment de la position du commutateur 40 de l'interface 3. Quand le capteur est fermé, le courant qui circule dépend uniquement de l'état de l'interrupteur 40 et ne comprends pas le courant d'alimentation du capteur. Par conséquent, l'économie en termes de dissipation est moindre que pour un capteur deux fils.

Les modes de réalisation décrits permettent de réduire la dissipation d'un circuit d'interface. Cette diminution de la dissipation permet de prévoir des circuits intégrés ayant un nombre d'entrées plus important.

Des modes de réalisation particuliers de la présente invention ont été décrits. Diverses variantes et modifications apparaîtront à l'homme de l'art. En particulier, bien que l'invention ait été décrite en relation avec une application plus particulièrement adaptée à la norme 61131-2, elle s'applique plus généralement dès que des problèmes similaires se posent. Par ailleurs, les dimensions à donner aux différents composants et notamment aux sources de courant et résistances du circuit d'interface dépendent de l'application et ce dimensionnement est à la portée de l'homme du métier à partir des indications fonctionnelles données ci-dessus et des capteurs concernés. Il en est de même pour le choix du rapport cyclique du signal de commande.

## Revendications

1. Circuit de conversion de l'état d'un capteur (2ᵢ) en un signal interprétable par un circuit électronique, comportant :
un comparateur (32) du niveau de tension d'une borne d'entrée (30i) par rapport à un niveau de référence (REF); et
un élément limiteur de courant (34),
**caractérisé en ce que** :
le capteur est destiné à être connecté entre une borne d'application d'une première tension d'alimentation (V₁) et la borne d'entrée du comparateur ;
un élément de commutation (40) destiné à être commandé par un train d'impulsions et un indicateur visuel (36) associé à un interrupteur (38) commandé par la sortie du comparateur sont connectés en série entre ladite borne d'entrée et la masse avec ledit élément limiteur de courant.

2. Circuit selon la revendication 1, dans lequel le rapport cyclique du train d'impulsions est supérieur à 10% et, préférentiellement, supérieur à 25%.

3. Circuit selon la revendication 1 ou 2, dans lequel le capteur (2ᵢ) a une réponse impulsionnelle capacitive à l'état inactif.

4. Circuit selon l'une quelconque des revendications 1 à 3, dans lequel le capteur (2ᵢ) est un capteur deux fils.

5. Circuit intégré comportant plusieurs circuits selon l'une quelconque des revendications 1 à 4.

6. Procédé d'acquisition de l'état d'un capteur (2ᵢ) à destination d'un circuit électronique (1), par un circuit (3) conforme à l'une quelconque des revendications 1 à 4, dans lequel des instants d'échantillonnage (CS) d'un signal fourni par le comparateur (32) sont synchronisés avec des fronts descendants des impulsions de commande de l'élément de commutation (40).

## Patentansprüche

1. Eine Schaltung zum Umwandeln des Zustandes eines Sensors (2ᵢ) in ein, durch eine elektronische Schaltung interpretierbares Signal, wobei Folgendes vorgesehen ist:
ein Komparator (32) des Spannungspegels eines Eingangsanschlusses (30ᵢ) bezüglich eines Referenzpegels (REF); und
ein Strombegrenzungselement (34),
**dadurch gekennzeichnet dass**:
der Sensor zur Verbindung vorgesehen ist, zwischen einem Anschluss zum Anlegen einer ersten Leistungsversorgungsspannung (V₁) und dem Eingangsanschluss des Komparators;
ein Schaltelement (40) vorgesehen zur Steuerung durch eine Impulsfolge, und eine visuelle Anzeigevorrichtung (36) assoziiert mit einem Schalter (38) gesteuert durch den Ausgang des Komparators, sind in Serie geschaltet zwischen dem Eingangsanschluss und der Erde mit dem Strombegrenzungselement.

2. Die Schaltung nach Anspruch 1, wobei der Betriebszyklus der Impulsfolge größer als 10% ist, und vorzugsweise größer als 25% ist.

3. Die Schaltung nach Anspruch 1 oder 2, wobei der Sensor (2ᵢ) im inaktiven Zustand ein kapazitives Impulsansprechen besitzt.

4. Die Schaltung nach einem der Ansprüche 1 bis 3, wobei der Sensor (2ᵢ) ein Zweit-Draht-Sensor ist.

5. Eine integrierte Schaltung, die mehrere Schaltungen gemäß einem der Ansprüche 1 bis 4 aufweist.

6. Ein Verfahren zum Erfassen des Zustands eines Sensors (2ᵢ) für eine elektronische Schaltung (1), durch die Schaltung (3) nach einem der Ansprüche 1 bis 4, wobei die Tastzeiten (CS) eines Signals vorgesehen durch den Komparator (32) synchronisiert sind mit den fallenden Kanten der Steuerimpulse des Schaltelements (40).

## Claims

1. A circuit for converting the state of a sensor (2i) into a signal interpretable by an electronic circuit, comprising:
a comparator (32) of the voltage level of an input terminal (30i) with respect to a reference level (REF); and
a current-limiting element (34),
**characterized in that**:
the sensor is intended to be connected between a terminal of application of a first power supply voltage (V₁) and the input terminal of the comparator;
a switching element (40) intended to be controlled by a pulse train and a visual indicator (36) associated with a switch (38) controlled by the output of the comparator are series connected between said input terminal and the ground with said current-limiting element.

2. The circuit of claim 1, wherein the duty cycle of the pulse train is greater than 10% and, preferably, greater than 25%.

3. The circuit of claim 1 or 2, wherein the sensor (2i) has a capacitive impulse response in the inactive state.

4. The circuit of any of claims 1 to 3, wherein the sensor (2i) is a two-wire sensor.

5. An integrated circuit comprising several circuits according to any of claims 1 to 4.

6. A method of acquisition of the state of a sensor (2i) for an electronic circuit (1), by the circuit (3) of any of claims 1 to 4, wherein sampling times (CS) of a signal provided by the comparator (32) are synchronized with falling edges of the control pulses of the switching element (40).
